(19) **Europäisches Patentamt European Patent Office Office européen des brevets**

(11) **EP 1 923 426 B1**

(12) **EUROPEAN PATENT SPECIFICATION**

(45) Date of publication and mention
of the grant of the patent:
**23.03.2011 Bulletin 2011/12**

(51) Int Cl.:
*C08L 63/00* (2006.01) *C08K 3/00* (2006.01)
*H01L 23/12* (2006.01) *H01L 23/14* (2006.01)
*H05K 1/05* (2006.01)

(21) Application number: **06797402.2**

(22) Date of filing: **04.09.2006**

(86) International application number:
**PCT/JP2006/317479**

(87) International publication number:
**WO 2007/029657 (15.03.2007 Gazette 2007/11)**

(54) **RESIN COMPOSITION AND HYBRID INTEGRATED CIRCUIT BOARD MAKING USE OF THE SAME**

HARZZUSAMMENSETZUNG UND INTEGRIERTE HYBRIDLEITERPLATTE DAMIT

COMPOSITION DE RÉSINE ET CARTE À CIRCUIT INTÉGRÉ HYBRIDE UTILISANT LADITE COMPOSITION

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **05.09.2005 JP 2005256194**

(43) Date of publication of application:
**21.05.2008 Bulletin 2008/21**

(73) Proprietor: **DENKI KAGAKU KOGYO KABUSHIKI
KAISHA
Tokyo 103-8338 (JP)**

(72) Inventors:
• **MIYATA, Kenji,
Denki Kagaku Kogyo Kabushiki Kaisha
Shibukawa-shi, Gunma 3778520 (JP)**

• **ISHIKURA, Hidenori,
Denki Kagaku Kogyo Kabushiki Kaisha
Shibukawa-shi, Gunma 3778520 (JP)**

(74) Representative: **Hartz, Nikolai
Wächtershäuser & Hartz
Patentanwaltspartnerschaft
Weinstrasse 8
80333 München (DE)**

(56) References cited:
**JP-A- 2 286 768      JP-A- 02 286 768
JP-A- 05 239 321      JP-A- 06 044 824
JP-A- 2002 322 372    JP-A- 2003 292 734
JP-A- 2003 292 734    US-A- 5 254 605**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a resin composition which is suitably used as an insulating layer for a metal base circuit board because of being excellent in electrical insulation, having a high thermal conductivity and being excellent in adhesion to a heat-dissipating material, in particular a metal plate, for an electrical component or electronic component, the metal base circuit board having a circuit disposed on a metal plate through the insulating layer. The present invention also relates to a method for preparing the above-mentioned resin material, and a substrate for a hybrid integrated circuit and a circuit board, which make use of the resin composition.

BACKGROUND ART

There has been known a metal base circuit board which includes a circuit through an insulating layer made of a resin with an inorganic filler filled therein, and there also has been known a resin composition for such an insulating layer, which is densely filled with a spherical inorganic filler to have not only a sufficient adhesive force as an adhesive composition but also a high thermal conductivity (see Patent Document 1).

Patent Document 1:    JP-A-2-286768

DISCLOSURE OF INVENTION

PROBLEMS THAT THE INVENTION IS TO SOLVE

As examples of such a spherical inorganic filler, spherical silica and spherical alumina have been known. These materials have problems in that although these materials are able to be used for producing a substrate or a circuit board having excellent properties, these materials are expensive because of being produced by a specific production method using flame fusion or the like. For this reason, emphasis has been placed on using an inorganic filler as a crushed product readily available to produce a resin capable of accomplishing the above-mentioned properties in the industry.

It is an object of the present invention to provide a substrate and a circuit board, which, although being made of an inorganic filler as a crushed product, are capable of providing a highly reliable hybrid integrated circuit because of having excellent adhesion to a metal plate or metal foil and exhibiting a high thermal conductivity.

MEANS FOR SOLVING THE PROBLEM

The present invention is directed to a resin composition comprising a curable resin comprising an epoxy resin and a curing agent for the epoxy resin; and an inorganic filler filled in the curable agent; wherein the curing agent comprises a phenol novolak resin; as further defined in claim 1. The inorganic filler comprises a coarse powder containing particles having an average particle size of 5 to 20 $\mu$m, preferably particles having a maximum particle size of 100 $\mu$m or below and a particle size of 5 to 50 $\mu$m in an amount of 50 vol% or above. The fine powder contains particles having an average particle size of 0.2 to 1.5 $\mu$m, preferably particles having a particle size of 2.0 $\mu$m or below in an amount of 70 vol% or above. In a preferred mode, the above-mentioned resin composition is prepared so that the curable resin is in an amount of 25 to 50 vol%, and that the inorganic filler comprises a coarse powder in an amount of 34 to 70 vol% and a fine powder in an amount of 3 to 24 vol%. The above-mentioned resin composition is prepared so that at least the coarse powder comprises particles made of a crystalline silicon dioxide. In a particularly preferred mode, the above-mentioned resin composition is prepared so that each of the coarse powder and the fine powder comprises particles made of a crystalline silicon dioxide, or that the fine powder comprises particles made of a spherical aluminum oxide.

The present invention is directed to a resin-cured product comprising the above-mentioned resin composition, preferably having a thermal conductivity of 1.5 to 5.0 W/mK.

The present invention is directed to a substrate for a hybrid integrated circuit, which comprises a metal substrate; an insulating layer deposited on the metal substrate and comprising the above-mentioned resin composition; and metal foil disposed on the insulating layer.

The present invention is directed to a substrate for a hybrid integrated circuit, which comprises a metal substrate; an insulating layer deposited on the metal substrate and comprising the above-mentioned resin composition; and metal foil disposed on the insulating layer, wherein the metal foil is processed to form a circuit.

Further, the present invention is directed to a method for preparing the above-mentioned resin composition, which comprises mixing an epoxy resin and a curing agent of a phenol novolak resin; and blending and mixing an inorganic filler with the mixture before curing.

The present invention is directed to a metal base circuit board, which comprises a metal substrate; a first insulating layer disposed on the metal substrate and comprising the above-mentioned resin composition; a circuit disposed on the first insulating layer; a second insulating layer disposed on the first insulating layer and comprising the above-mentioned resin composition; and a circuit disposed on the second insulating layer.

EFFECT OF THE INVENTION

The resin composition according to the present invention has excellent adhesion to a metal plate or metal foil made of, e.g. aluminum, copper or an alloy thereof because of being made of a selected epoxy resin and a selected curing agent for the epoxy resin and containing a selected inorganic filler having a specific particle size distribution. The resin composition according to the present invention is suited for components having an excellent electrical insulation and an excellent thermal dissipation for an electrical component or electronic component, in particular a substrate for a hybrid integrated circuit and a circuit board, because of providing a resin-cured product having a high thermal conductivity.

The resin composition according to the present invention is able to provide a cured product having an excellent heat resistance.

The resin-cured product according to the present invention is not only excellent in adhesion to metal but also excellent in electrical insulation and thermal conductivity. Since the resin-cured product according to the present invention is as high as 1.5 to 5.0 W/mK in thermal conductivity in a preferred mode, the resin-cured product is suited for a heat dissipating material for an electrical component and electronic component containing a substrate for a hybrid integrated circuit, and a circuit board.

The substrate, the circuit board and the multilayer circuit board according to the present invention are able to be used to easily obtain a highly reliable hybrid integrated circuit because of making full use of the merits of a resin-cured product to be excellent in electrical insulation and thermal conductivity by using the above-mentioned resin composition.

The production method according to the present invention is able to prevent bubbles from staying in the resin composition by blending an epoxy resin, a curing agent for the epoxy resin and an inorganic filler in a specific order and mixing these materials. As a result, the resin-cured product produced by this production method achieves the advantages of stably having a high electrical insulation and a high electrical conductivity. Consequently, the production method according to the present invention is able to contribute to provide a highly reliable hybrid integrated circuit.

BEST MODE FOR CARRYING OUT THE INVENTION

The epoxy resin used in the present invention may comprise a known epoxy resin, such as a bisphenol A type epoxy resin, a bisphenol F type epoxy resin and a hydrogenated bisphenol A type epoxy resin. Among such resins, a bisphenol A type epoxy resin is preferably selected because of being excellent in electrical insulation and thermal conduction and being suited for obtaining a resin-cured product having an excellent heat resistance.

It is further preferred that the bisphenol A type epoxy resin have an epoxy equivalent of 300 or below. When the epoxy equivalent is 300 or below, it is possible to prevent the crosslink density of the bisphenol A type epoxy resin from being reduced to decrease Tg, consequently prevent heat resistance from being reduced as in a case where the bisphenol A type epoxy resin is of a high molecular type. Further, in this case, it is possible to prevent a problem that if the molecular weight of the curable resin increases, it is impossible to obtain a uniform resin composition because the curable resin changes from a liquid form to a solid form, making it difficult to blend an inorganic filler in the curable resin.

It is also preferred that the bisphenol A type epoxy resin have a hydrolysable chloride concentration of 600 ppm or below. When the hydrolysable chloride concentration is 600 ppm or below, the resin is able to be used to obtain a substrate for a hybrid integrated circuit having a sufficient moisture resistance.

The hydrolysable chloride concentration means the concentration of organic chloride impurities (chlorine ions that are hydrolyzed in the presence of water) formed by side reaction when synthesizing the epoxy resin

The present invention uses a phenol novolak resin as the curing agent for the above-mentioned epoxy resin. It is preferred that the phenol novolak resin have a number average molecular weight of 1,500. When the number average molecular weight is 1,500 or below, it is possible to prevent a problem that it is difficult to blend the inorganic filler in the curable resin because the softening point of the curable resin is high.

It is preferred that the phenol novolak resin have a hydrolyzable chloride concentration of 10 ppm, or below. When the hydrolyzable chloride concentration is 10 ppm or below, the phenol novolak resin is able to be used to obtain a substrate for a hybrid integrated circuit having a sufficient moisture resistance.

The present invention uses an inorganic filler having a specific particle size distribution. Specifically, the inorganic filler may comprise a mixed powder comprising (a) a coarse powder containing particles having a maximum particle size of 100 $\mu$m or below, a particle size of 5 to 50 $\mu$m in an amount of 50 vol% or above and an average particle size of 5 to 20 $\mu$m, and (b) a fine powder containing particles having a particle size of 2.0 $\mu$m or below in an amount of 70 vol% or above and an average particle size of 0.2 to 1.5 $\mu$m.

The coarse powder contains particles having a particle size of 5 to 50 $\mu$m in an amount of 50 vol%, preferably 60 vol% and an average particle size of 5 to 20 $\mu$m, preferably 10 to 15 $\mu$m. The fine powder contains particles having a particle size of 2.0 $\mu$m or below in an amount of 70 vol% and an average particle size of 0.2 to 1.5 $\mu$m, preferably 1.0 to 1.5 $\mu$m.

When a coarse powder and a fine powder, each of which has the above-mentioned specific particle distribution, are mixed and used, it is possible to attain the object of the present invention without using an inorganic filler containing a coarse powder and a fine powder, each of which is made of spherical particles.

The inorganic filler applicable to the present invention may comprise any material, such as an aluminum oxide, a silicon dioxide, a magnesium oxide, an aluminum nitride, a silicon nitride and a boron nitride, as long as a selected material has an electrical insulation and is a more excellent thermal conductivity than the resin. Among them, the coarse powder comprises particles made of a crystalline silicon dioxide (quartz) because of having a thermal conductivity of 12 W/mK (laser flash method) or above. When the resin composition and the cured product thereof according to the present invention are used as a heat dissipating material for an electrical or electronic component used at a high frequency, such crystalline silicon dioxide is preferably selected in terms of ease in ensuring a required electrical insulation because of having a dielectric constant of 4.0 or below (at 25°C and at 1 MHz).

In terms of ease in ensuring a sufficient moisture resistance as a substrate for a hybrid integrated circuit, it is preferred that the above-mentioned crystalline silicon dioxide have an electrical conductivity of 50 $\mu$S/cm or below or contain ionic impurities of $Cl^-$ or $Na^+$ in an amount of 20 ppm or below.

Although crushed products made of any one of the above-mentioned materials may be of course used as the fine powder of the inorganic filler according to the present invention, a fine powder comprising particles made of the above-mentioned crystalline silicon dioxide is preferably used because of being capable of obtaining a resin-cured product having a low dielectric constant, a high electrical insulation and a high thermal conductivity, which are influenced by the features of the crystalline silicon dioxide. The inorganic filler is preferably made of spherical particles, such as spherical silica particles or spherical alumina particles, because of being capable of increasing the flowability of the resin composition to further increase the filling amount of the inorganic filler, with the result that it is possible to obtain a resin-cured product having a high electrical insulation and a high thermal conductivity.

In the present invention, the curable resin and the inorganic filler are preferably blended in such a blending ratio that the curable resin is in an amount of 25 to 50 vol% and that the inorganic filler contains a coarse powder in an amount of 34 to 70 vol% and a fine powder in an amount of 3 to 24 vol%, are more preferably blended in such a blending ratio that the curable resin is in an amount of 28 to 45 vol% and that the inorganic filler contains a coarse powder in an amount of 40 to 60 vol% and a fine powder in an amount of 10 to 22 vol%. When the blending ratio is within the above-mentioned ranges, it is possible not only to uniformly blend the curable resin and the inorganic filler and to avoid porous formation but also to densely fill the inorganic filler in the curable resin, with the result that it is possible to stably obtain a resin-cured product having an excellent thermal conductivity and an excellent electrical insulation. When a substrate, a circuit board or a hybrid integrated circuit is fabricated by using the above-mentioned curable resin and inorganic filler, the substrate, the circuit board or the hybrid integrated circuit is highly reliable.

Several known methods are applicable to the method for preparing the resin composition according to the present invention. However, it is preferred to employ the following method since it is possible to prevent bubbles from being involved in the resin composition and to stably obtain a resin-cured product which is excellent in adhesion to metal, has a high electrical insulation and is excellent in thermal conductivity.

The method for preparing the resin composition according to the present invention is characterized in that an epoxy resin is mixed with a curing agent made of a phenol novolak resin, followed by blending and mixing an inorganic filler with the mixture before curing. The mixer employed in this method may comprise a known mixer, such as a versatile stirring mixer, a sun-and-planet stirring/defoaming device and a pressure kneader. The mixing conditions may be properly determined. The mixing process is not required to have specific conditions.

The resin-cured product according to the present invention is characterized to be a product obtainable by curing the above-mentioned resin composition, to have a high electric isolation and a high thermal conductivity, and to be excellent in adhesion to metal, such as aluminum, copper and an alloy thereof. Although the resin-cured product according to the present invention is applicable as the insulating material for various kinds of electrical components or electronic components, the resin-cured product is particularly suited to be used as an insulating layer for a substrate for a hybrid integrated circuit, and a circuit board. In a preferred embodiment, the resin-cured product according to the present invention is as high as 1.5 to 5.0 W/mK in thermal conductivity.

Each of the substrate and the circuit board according to the present invention is configured so that the above-mentioned resin composition is disposed as an insulating layer on a metal plate, and metal foil, which is made of aluminum, copper an alloy thereof etc., or a circuit, which is obtained by subjecting the metal foil to, e.g. etching, is disposed on the insulating layer. The substrate and the circuit board according to the present invention are suited to be used in a hybrid integrated circuit because of being excellent in withstand voltage characteristics and being excellent in thermal dissipation, being influenced by the merits of the resin composition or the cured product thereof. In a preferred embodiment, each of the coarse powder and the fine powder of the inorganic filler comprises particles made of a crystalline silicon dioxide. The substrate and the circuit board according to this preferred embodiment are suited as a substrate for an integrated circuit using a high frequency and a circuit board using a high frequency because of having a low dielectric capacitance.

The metal base multilayer circuit board according to the present invention is configured so that the above-mentioned resin composition is disposed as an insulating layer on the above-mentioned circuit board, and metal foil, which is made of, e.g. aluminum, copper or an alloy thereof, or a circuit, which is obtained by subjecting the metal foil to, e.g. etching, is disposed on the insulating layer. The metal base multilayer circuit board may be suited to be used in a hybrid integrated circuit because of having the advantage of improving the circuit packaging density. The metal base multilayer circuit board is suited to be used in a hybrid integrated circuit because of being excellent in withstand voltage characteristics and being excellent in thermal dissipation, being influenced by the merits of the above-mentioned resin composition or the cured product thereof. In the above-mentioned preferred embodiment, each of the coarse powder and the fine powder of the inorganic filler comprises particles made of a crystalline silicon dioxide. The metal base multilayer circuit board according to this preferred embodiment is suited to be as a substrate for an integrated circuit using a high frequency and a circuit board using a high frequency because of having a low dielectric capacitance.

EXAMPLE

EXAMPLE 1

55 Parts by mass of a crystalline silicon dioxide ("A-1" manufactured by Tatsumori Ltd.,: having a maximum particle size of 96 $\mu$m (100 $\mu$m or below), containing particles having a particle size of 5 to 50 $\mu$m in 60 vol% and having an average particle size of 12 $\mu$m) as the coarse powder of the inorganic filler was mixed with 14 parts by mass of a crystalline silicon dioxide ("5X" manufactured by Tatsumori Ltd.,: containing particles having a particle size of 2.0 $\mu$m or below in 70 vol% and having an average particle size of 1.2 $\mu$m) as the fine powder of the inorganic filler to prepare a raw inorganic filler.

9 Parts by mass of a phenol novolak resin ("TD-2131" manufactured by Dainippon Ink and Chemicals Incorporated) and 1 parts by mass of a silane coupling agent ("A-187" manufactured by Nippon Unicar Company Limited), both of which served as a curing agent, were added to 20 parts by mass of a bisphenol A type liquid epoxy resin ("EP828" manufactured by Japan Epoxy Resins Co., Ltd.), and the above-mentioned raw inorganic filler was added thereto, being kneaded by a kneader at a heating temperature of 90°C, to prepare resin composition (a) for a circuit board.

0.05 Parts by mass of an imidazole-based curing accelerator ("TBZ" manufactured by SHIKOKU CHEMICALS CORPORATION) as the curing accelerator was added to 100 parts by mass of resin composition (a) to obtain resin composition (b).

Resin composition (b) was heated at a temperature of 150°C for one hour and was further heated at a temperature of 180°C for two hours to obtain a resin-cured product. When the thermal conductivity of the resin-cured product thus obtained was measured by the laser flash method, it was revealed that the thermal conductivity was 1.7 W/mK. The results are shown in Table 1.

TABLE 1

| Material name | | Ex. 1 | Ex. 2 | Ex. 3 | Ex. 4 | Ex. 5 | Ex. 6 |
|---|---|---|---|---|---|---|---|
| Epoxy resin | Bisphenol A type epoxy resin | 20 | 20 | 20 | 20 | 20 | 20 |
| Curing agent | Phenol novolak resin | 9 | 9 | 9 | 9 | 9 | 9 |
| | Amino-based curing agent | - | - | - | - | - | - |
| Curing accelerator | Imidazole-based curing accelerator | 0.05 | 0.05 | 0.05 | 0.05 | 0.05 | 0.05 |
| Coupling agent | Silane-based coupling agent | 1 | 1 | 1 | 1 | 1 | 1 |
| Coarse | Crystalline silicon dioxide powder | 55 | 71 | 8:3 | 99 | 132 | 163 |
| | Aluminum oxide (in spherical form) | - | - | - | - | - | - |
| Fine powder | Crystalline silicon dioxide | 14 | 18 | 21 | 25 | - | - |
| | Aluminum oxide (in spherical form) | - | - | - | - | 57 | 70 |
| Filling amount of inorganic filler (vol%) | | 50 | 56 | 60 | 64 | 71 | 75 |

Resin composition (b) was applied to a 1.5 mm thick aluminum plate so as to have a thickness of 80 $\mu$m after curing, and the applied resin composition was heated at a temperature of 100°C for 0.1 hours to be semi-cured, 210 $\mu$m thick copper foil was deposited on semi-cured resin composition (b), and semi-cured resin composition (b) with the copper foil thereon was heated at a temperature of 180°C for 2 hours to finish the curing process, fabricating a substrate for a hybrid integrated circuit.

The substrate for a hybrid integrated circuit thus fabricated was measured in terms of various characteristics as stated below. The results are shown in Table 2.

TABLE 2

| Item | | Unit | Ex. 1 | Ex. 2 | Ex. 3 | Ex. 4 | Ex. 5 | Ex. 6 |
|---|---|---|---|---|---|---|---|---|
| Flowability | Viscosity | cps | 74,000 | 80,000 | 104,000 | 152,000 | 141,000 | 182,000 |
| Adhesion | | | Good | Good | Good | Good | Good | Good |
| Withstand voltage | Initial stage | kV | 6.5 | 6.0 | 6.0 | 6.0 | 5.0 | 4.8 |
| | After 96 hr under Pressure Cooker Test | | 6.5 | 6.5 | 6.5 | 6.5 | 6.5 | 6.0 |
| Heat resistance | 200°C 500 hr | kV | 4.7 | 4.3 | - | - | 3.6 | - |
| Reliability of thick copper foil | Fracture in insulating layer | | Not found | Not found | Not found | Not found | Not found | Not found |
| | 260°C 2 min | kV | 6.0 | 5.5 | 5.5 | 5.5 | 4.6 | 4.6 |
| Peel strength | | Kgf/cm | 2.1 | 2.2 | 2.1 | 1.9 | 2.1 | 1.9 |
| Heat resistance | | °C/W | 0.31 | 0.26 | 0.21 | 0.19 | 0.14 | 0.12 |
| Thermal conductivity | | W/mK | 1.7 | 2.0 | 2.5 | 2.9 | 4.9 | 4.9 |
| Dielectric constant | | | 4.3 | 4.3 | 4.2 | 4.1 | 4.9 | 4.9 |
| Dielectric dissipation factor | | | 0.004 | 0.004 | 0.003 | 0.003 | 0.002 | 0.002 |
| Processability | | mm | - | 0.0 | - | - | 1.0 | - |
| Withstand voltage for creeping discharge | | kW | - | 3.2 | - | - | 3.3 | - |
| Power loss | | W | - | 5.9 | - | - | 6.1 | - |

Adhesion: The substrate for a hybrid integrated circuit with the copper foil removed by etching was cut into pieces having dimensions of 2 cm x 10 cm, and the pieces were bent at an angle of 90 degrees. The pieces without the insulating layer peering off the aluminum plate were determined as "good", and the piece with the insulating layer peering off the aluminum plate was determined as "no good".

Flowability: The viscosity was measured by a Model B viscometer. The pieces having a viscosity of higher than 200,000 cps at room temperature (25°C) were determined as "no good", and the pieces having a viscosity of 200,000 cps or below at room temperature (25°C) were determined as "good".

Withstand Voltage: In order to obtain a sample for measurement, copper foil was circumferentially etched so as to leave a 20 mm diameter circular portion therein. The withstand voltages of the sample, which had before and after being exposed at a temperature of 121°C, at a humidity of 100%RH and at an atmospheric pressure of 2 for 96 hours, were measured according to Japanese Industrial Standards C2110 by immersing the sample in an insulation oil and applying an AC voltage between the copper foil and the aluminum plate at room temperature. The measuring instrument was "TOS-8700" manufactured by KIKUSUI ELECTRONICS CORPORATION. With respect to the multilayer circuit board, the measurement was performed by applying an AC voltage between the copper foil and the circuit formed in an inner layer.

Peel Strength: The sample for measurement was prepared by processing the substrate so as to leave a portion of the copper foil having a width of 10 mm. The copper foil and the substrate were bent at an angle of 90 degrees, and an attempt was made to peel the copper from the substrate at a pulling speed of 50 mm/min. The other conditions were set according to Japanese Industrial Standards C6481. The measuring instrument was a product in the name of "TESNILON" ("U-1160" manufactured by TOYO BALDWIN. CO., LTD).

Dielectric Dissipation Factor: In order to obtain a sample for measurement, copper foil was circumferentially etched so as to leave a 20 mm diameter circular portion therein. The measurement was performed under the conditions of a temperature of 25°C and a frequency of 1 MHz according to Japanese Industrial Standards C6481. The measuring instrument was an LCR meter ("HP4284" manufactured by Yokogawa Hewlett-Packard Company).

Dielectric Constant: Electrostatic capacity (X; Y) was measured under the same conditions as the above-mentioned dielectric dissipation factor according to Japanese Industrial Standards C6481. Dielectric constant (E) was calculated based on the measured electrostatic capacity (X;F), the thickness of the insulating layer (Y;m), the area of the electrode (Z;m$^2$) and the permissibility of vacuum ($8.85 \times 10^{-12}$;F/m) by using the formula of $E = X \cdot Y / (Z \cdot 8.85 \times 10^{-12})$.

Heat Resistance: After a sample was left in a temperature chamber ("PHH-201" manufactured by ESPEC CORP) set at a temperature of 200°C for 500 hours, the sample was cooled on a wooden piece, the cooled sample was immersed in the insulation oil, an AC voltage was applied between the copper foil and the aluminum plate at room temperature in order to see a breakdown voltage.

Reliability of Thin Copper Foil: A sample was evaluated as a substrate for a hybrid integrated circuit, which included copper foil having a thickness of greater than 210 $\mu$m. After the sample was floated on a bath of solder set at a temperature of 260°C for 2 minutes, the sample was cooled on a wooden piece, immersed in the insulation oil, and a breakdown voltage was measured by applying an AC voltage between the copper foil and the aluminum plate of the sample at room temperature. Additionally, the cross section of the sample subjected to such process was observed (by a scanning electron microscope) to evaluate whether the insulating layer was fractured at the intersurface of the copper foil and the insulating layer of the sample or not.

Value of Heat Resistance: The sample for measurement was prepared by cutting out, from the test specimen, a piece having dimensions of 3x4 cm so as to leave a portion of the copper foil having dimensions of $10 \times 15$ mm. A TO-220 transistor was soldered onto a copper foil, and the copper foil with the transistor soldered thereon was fixed through heat dissipating grease on heat dissipating fins, which were water-cooled. The transistor was energized to generate heat. The value of heat resistance of the sample to be found (A;K/W) was measured by measuring the temperature difference between the surface of the transistor and the backside of the metal substrate to obtain a value of heat resistance and compensating the obtained value, taking the value of heat resistance of the heat dissipating grease into account.

Thermal Conductivity: The thermal conductivity (H;W/mK) was found based on the above-mentioned value of heat resistance (A;K/W), the thickness of the insulating layer of the sample (B;m) and the mounting area of the transistor (C;m$^2$) by using the formula of $H = B / (A \cdot C)$ .

Processability: Holes were made in the substrate for a hybrid integrated circuit by a punch. The depth of wear of the punch was measured after 10,000 shots.

Withstand Voltage for Creeping Discharge: A linear copper circuit was so as to be away from a creeping surface of a substrate for a hybrid integrated circuit by 2 mm as a sample for measurement. An AC voltage was applied between the copper foil circuit and the aluminum plate at room temperature to measure a voltage that generates creeping discharge.

Power Loss: First, the electrostatic capacity (X;F) was measured according to Japan Industrial Standard C6481 under the same conditions as above-mentioned dielectric loss. The power loss (G) was found based on the electrostatic capacity (X;F), the operating frequency of the device (H;400 kHz) and the operating voltage (I;220 V) by using the formula of

$$G = (X \times I^2 \times H) / 2 .$$

EXAMPLES 2 to 6

The resin composition, the resin-cured product, the substrate, the circuit board, the hybrid integrated circuit in each of these examples were fabricated and evaluated in the same way as those in Example 1 except that the kinds and the blending ratios of the coarse powder and the fine powder of the inorganic filler were changed as shown in Table 1. The results of evaluation are shown in Table 1 and Table 2.

Comparative Examples 1 to 6

The resin composition, the resin-cured product, the substrate, the circuit board, the hybrid integrated circuit in each of these comparative examples were fabricated and evaluated in the same way as those in Example 1 except that the kinds and the blending ratios of the curing agent, the coarse powder and the fine powder were changed. The results of evaluation are shown in Table 3 and Table 4.

TABLE 3

| Material name | | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|
| Epoxy resin | Bisphenol A type epoxy resin | 20 | 20 | 20 | 20 | 20 | 20 |
| Curing agent | Phenol novolak resin | - | - | 9 | 9 | 9 | 9 |
| | amino-based curing agent | 6 | 6 | - | - | - | - |
| Curing accelerator | Imidazole-based curing accelerator | - | - | 0.05 | 0.05 | 0.05 | 0.05 |
| Coupling agent | Silane-based coupling agent | 1 | 1 | 1 | 1 | 1 | 1 |
| Coarse powder | Crystalline silicon dioxide | - | - | 136 | - | - | - |
| | Aluminum oxide (in spherical form) | 62 | 117 | - | 74 | 98 | 127 |
| Fine powder | Crystalline silicon dioxide | - | - | 34 | - | 42 | 54 |
| | Aluminum oxide (in spherical form) | 27 | 50 | - | 32 | - | - |
| Filling amount of inorganic filler (vol%) | | 51 | 66 | 71 | 51 | 60 | 66 |

TABLE 4

| Item | | Unit | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|---|
| Flowability | Viscosity | cps | 66,000 | 72,000 | 450,000 | 58,000 | 74,000 | 95,000 |
| Adhesion | | | Good | Good | Bad | Good | Good | Good |

(continued)

| Item | | Unit | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|---|
| Withstand voltage | Initial stage | kV | 5.5 | 5.2 | 5.8 | 4.8 | 4.6 | 4.1 |
| | After 96 hr under Pressure Cooker Test | | 5.5 | 5.5 | 6.0 | 5.0 | 4.5 | 4.5 |
| Heat resistance | 200°C 500 hr | kV | 1.2 | 1.1 | - | 3.5 | - | - |
| Reliability of thick copper foil | Fracture in insulating layer | | Found | Found | Not found | Not found | Not found | Not found |
| | 260°C 2 min | kV | 2.8 | 2.8 | 5.5 | 4.4 | 4.2 | 4.0 |
| Peel strength | | Kgf/cm | 2.2 | 2.2 | 0.9 | 2.1 | 2.2 | 2.1 |
| Heat resistance | | °C/W | 0.11 | 0.26 | 0.13 | 0.26 | 0.18 | 0.13 |
| Thermal conductivity | | W/mK | 2.0 | 4.0 | 1.1 | 2.0 | 3.0 | 4.0 |
| Dielectric constant | | | 7.1 | 7.9 | 3.9 | 7.1 | 6.9 | 7.4 |
| Dielectric dissipation factor | | | 0.004 | 0.005 | 0.002 | 0.004 | 0.004 | 0.004 |
| Processability | | mm | 2.0 | 4.0 | - | 2.0 | - | - |
| Withstand voltage for creeping discharge | | kW | 2.6 | 2.4 | - | 2.6 | - | - |
| Power loss | | W | 9.5 | 10.6 | - | 9.6 | - | - |

EXAMPLE 7

Resin composition (b) prepared in Example 2 was applied on an aluminum plate having a thickness of 1.5 mm so as to form a first insulating layer having a thickness of 150 $\mu$m after curing, and was heated at a temperature of 100°C for 0.1 hour to be semi-cured. Then, copper foil having a thickness of 35 $\mu$m was disposed on semi-cured resin composition (b), and the resin composition was further heated at a temperature of 180°C for 2 hours, finishing the curing process. The above-mentioned resin composition (b) was applied on the prepared circuit board so as to form a second insulating layer having a thickness of 50 $\mu$m after curing, and was heated at a temperature of 100°C for 0.1 hour to be semi-cured. Then, copper foil having a thickness of 210 $\mu$m was disposed on semi-cured resin composition (b), and the resin composition was further heated at 180°C for 2 hours to finish the curing process, fabricating a multilayer substrate for a hybrid integrated circuit. The substrate fabricated was evaluated. The results of evaluation are shown in Table 5, Table 6 and Table 7.

EXAMPLE 8

The multilayer circuit board was fabricated and evaluated in the same way as that of Example 7 except that the thickness of the second insulating layer was changed to 200 $\mu$m. The results of evaluation are shown in Table 5, Table 6 and Table 7.

COMPARATIVE EXAMPLES 7 and 8

The resin composition, the resin-cured product, the substrate, the circuit board, the hybrid integrated circuit in each of these comparative examples were fabricated and evaluated in the same way as those in Example 7 except that the kinds and the blending ratios of the curing agent, the coarse powder and the fine powder were changed and except that the thickness of the second insulating layer was changed in Comparative Example 8. The results of evaluation are shown in Table 5, Table 6 and Table 7.

TABLE 5

| Material name | | Ex. 7 and 8 | Comp. Ex. 7 and 8 |
|---|---|---|---|
| Epoxy resin | Bisphenol A type epoxy resin | 20 | 20 |
| Curing agent | Phenol novolak resin | 9 | - |
| | amino-based curing agent | - | 6 |
| Curing accelerator | Imidazole-based curing accelerator | 0.05 | - |
| Coupling agent | Silane-based coupling agent | 1 | 1 |
| Coarse powder | Crystalline silicon dioxide | 71 | - |
| | Aluminum oxide (in spherical form) | - | 62 |
| Fine powder | Crystalline silicon dioxide | 18 | - |
| | Aluminum oxide (in spherical form) | - | 27 |
| Filling amount of inorganic filler (vol%) | | 56 | 51 |

TABLE 6

| | | | | | unit: mm |
|---|---|---|---|---|---|
| Formation | Material | Ex. 7 | Ex. 8 | Comp. Ex. 7 | Comp. Ex. 8 |
| Base material | Aluminum | 1.5 | 1.5 | 1.5 | 1.5 |
| First insulating layer | Refer to Table 5 | 0.15 | 0.15 | 0.15 | 0.15 |
| Circuit in outer layer | Copper foil | 0.035 | 0.035 | 0.035 | 0.035 |
| Second insulating layer | Refer to Table 5 | 0.05 | 0.2 | 0.05 | 0.2 |
| Circuit in inner layer | Copper foil | 0.21 | 0.21 | 0.21 | 0.21 |

TABLE 7

| Item | | Unit | Ex. 7 | Ex. 8 | Comp. Ex. 7 | Comp. Ex. 8 |
|---|---|---|---|---|---|---|
| Flowability | Viscosity | cps | 80,000 | 80,000 | 66,000 | 66,000 |
| Adhesion | | | Good | Good | Good | Good |
| Withstand voltage | Initial stage | kV | 4.6 | 10.0 | 4.5 | 10.0 |
| | After 96 hr under Pressure Cooker Test | | 5.0 | 10.0 | 4.6 | 10.0 |
| Heat resistance | 200°C 500 hr | kV | - | 10.0 | - | 10.0 |
| Reliability of thick copper foil | Fracture in insulating layer | | Not found | Not found | Found | Found |
| | 260°C 2 min | KV | 4.2 | 10.0 | 4.2 | 10.0 |
| Peel strength | | Kgf/cm | 2.0 | 2.2 | 2.0 | 2.1 |
| Heat resistance | | °C/W | 1.21 | 1.92 | 1.28 | 2.01 |
| Thermal conductivity | | W/mK | 2.0 | 2.0 | 2.0 | 2.0 |

(continued)

| Item | Unit | Ex. 7 | Ex. 8 | Comp. Ex. 7 | Comp. Ex. 8 |
|---|---|---|---|---|---|
| Dielectric constant | | 4.4 | 4.4 | 7.1 | 7.1 |
| Dielectric dissipation factor | | 0.004 | 0.005 | 0.004 | 0.004 |
| Processability | mm | - | 2.0 | - | 4.0 |
| Withstand voltage for creeping discharge | kW | - | 6.4 | - | 5.2 |
| Power loss | W | 2.4 | 1.3 | 3.8 | 2.2 |

INDUSTRIAL APPLICABILITY

The resin composition according to the present invention is suited to an insulating layer for, e.g. a substrate for a hybrid integrated circuit since a combination of an inorganic filler having a specific particle size and a specific resin provides a high electrical insulation, a high thermal conductivity and excellent adhesion to metal. The resin composition according to the present invention is applicable to a heat dissipating material for various kinds of electrical components and electronic components, such as a substrate for a hybrid integrated circuit and a circuit board, and is significantly effective in terms of industry because of being capable of providing a resin-cured product having a lower dielectric constant and a resin-cured product having a further excellent thermal conductivity in a preferred embodiment.

The substrate for a hybrid integrated circuit and the circuit board according to the present invention are excellent in withstand voltage characteristics, thermal dissipation and high frequency characteristics because being made of a resin composition having the above-mentioned merits. When the substrate or the circuit board according to the present invention is utilized to fabricate a hybrid integrated circuit, the reliability of the hybrid integrated circuit is increased, which means that the substrate and the circuit board according to the present invention are significant effective in terms of industry.

The method for preparing the resin composition according to the present invention is capable of realizing the excellent properties of the above-mentioned resin composition by only specifying the mixing order of the materials. The method according to the present invention is capable of stably providing a resin-cured product having excellent properties and a substrate for a hybrid integrated circuit or a circuit board using such a resin-cured product, and consequently providing a reliable hybrid integrated circuit, which means that the method according to the present invention is significant effective in terms of industry.

**Claims**

1.   A resin composition comprising a curable resin comprising:

an epoxy resin and a curing agent for the epoxy resin; and
an inorganic filler filled in the curable agent;
wherein the curing agent comprises a phenol novolak resin, and wherein the inorganic filler comprises a coarse powder containing particles having an average particle size of 5 to 20 $\mu$m and a fine powder containing particles having an average particle size of 0.2 to 1.5 $\mu$m;
wherein at least the coarse powder comprises particles having crystalline silicon dioxide.

2.   The resin composition according to Claim 1, wherein the inorganic filler comprises coarse powder containing particles having a maximum particle size of 100 $\mu$m or below and a particle size of 5 to 50 $\mu$m in an amount of 50 vol% or above, and a fine powder containing particles having a particle size of 2.0 $\mu$m or below in an amount of 70 vol% or above.

3.   The resin composition according to Claim 1 or 2, wherein the curable resin is in an amount of 25 to 50 vol%, and wherein the inorganic filler comprises a coarse powder in an amount of 34 to 70 vol% and a fine powder in an amount of 3 to 24 vol%.

4.   The resin composition according to any one of Claims 1 to 3, wherein each of the coarse powder and the fine powder comprises particles made of a crystalline silicon dioxide.

5. The resin composition according to Claim 1, wherein the fine powder comprises particles made of a spherical aluminum oxide.

6. A resin-cured product comprising the resin composition defined in any one of Claims 1 to 5.

7. The resin-cured product according to Claim 6, having a thermal conductivity of 1.5 to 5.0 W/mK.

8. A substrate for a hybrid integrated circuit, comprising a metal substrate; an insulating layer deposited on the metal substrate and comprising the resin composition defined in any one of Claims 1 to 5; and metal foil disposed on the insulating layer.

9. The substrate for a hybrid integrated circuit according to claim 8, wherein the metal foil is processed to form a circuit.

10. A method for preparing the resin composition defined in any one of Claims 1 to 5, comprising mixing an epoxy resin and a curing agent of a phenol novolak resin; and blending and mixing an inorganic filler with the mixture before curing.

11. A metal base multilayer circuit board comprising a metal substrate; a first insulating layer disposed on the metal substrate and comprising the resin composition defined in any one of Claims 1 to 5; a circuit board disposed on the first insulating layer; a second insulating layer disposed on the first insulating layer and comprising the resin composition defined in any one of Claims 1 to 5; and an electronic component disposed on the second insulating layer, the electronic component having a high heat dissipation.

12. The metal base multilayer circuit board according to Claim 11, further comprising a metal layer disposed between the first insulating layer and the second insulating layer.

13. The metal base multilayer circuit board according to Claim 11 or 12, wherein the second insulating layer has a thickness of 50 $\mu$m or above and 200 $\mu$m or below.


**Patentansprüche**

1. Harzzusammensetzung umfassend ein härtbares Harz umfassend:

   ein Epoxyharz und einen Härter für das Epoxyharz; und
   einen anorganischen Füllstoff, mit dem das härtbare Harz gefüllt ist;
   wobei der Härter ein Phenol-Novolak Harz enthält und worin der anorganische Füllstoff ein grobes Pulver umfasst, das Partikel mit einer durchschnittlichen Partikelgröße von 5 bis 20 Mikrometer enthält, und ein feines Pulver, das Partikel mit einer durchschnittlichen Partikelgröße von 0,2 bis 1,5 Mikrometer enthält;
   wobei zumindest das grobe Pulver Partikel enthält, die kristallines Siliziumdioxid enthalten.

2. Die Harzzusammensetzung gemäß Anspruch 1, worin der anorganische Füllstoff grobes Pulver enthält, das Partikel mit einer maximalen Partikelgröße von 100 Mikrometern oder weniger und einer Partikelgröße von 5 bis 50 Mikrometern in einer Menge von 50 Volumen-Prozent oder mehr enthält, und ein feines Pulver, das Partikel mit einer Partikelgröße von 2,0 Mikrometer oder weniger in einer Menge von 70 Volumen-Prozent oder mehr enthält.

3. Die Harzzusammensetzung gemäß Anspruch 1 oder 2, worin das härtbare Harz in einer Menge von 25 bis 50 Volumen-Prozent vorliegt, und worin der anorganische Füllstoff ein grobes Pulver in einer Menge von 34 bis 70 Volumen-Prozent und ein feines Pulver in einer Menge von 3 bis 24 Volumen-Prozent enthält.

4. Die Harzzusammensetzung gemäß einem der Ansprüche 1 bis 3, worin sowohl das grobe Pulver als auch das feine Pulver Partikel enthält, die aus kristallinem Siliziumdioxid bestehen.

5. Die Harzzusammensetzung gemäß Anspruch 1, worin das feine Pulver Partikel aus einem sphärischen Aluminiumoxid enthält.

6. Gehärtetes Harzprodukt umfassend die Harzzusammensetzung wie in einem der Ansprüche 1 bis 5 definiert.

7. Das gehärtete Harzprodukt gemäß Anspruch 6, das eine thermische Leitfähigkeit von 1,5 bis 5,0 W/mk aufweist.

**8.** Substrat für eine hybride integrierte Schaltung, umfassend ein Metallsubstrat; eine Isolierschicht, die auf dem Metallsubstrat abgeschieden ist und die Harzzusammensetzung wie in einem der Ansprüche 1 bis 5 definiert enthält; und eine Metallfolie auf der Isolierschicht.

**9.** Das Substrat für eine hybride integrierte Schaltung gemäß Anspruch 8, worin die Metallfolie prozessiert ist, um eine Schaltung zu bilden.

**10.** Verfahren zur Herstellung der Harzzusammensetzung wie in einem der Ansprüche 1 bis 5 definiert, umfassend Mischen eines Epoxyharzes und eines Härters aus einem Phenol-Novolak-Harz; und Vermengen und Vermischen eines anorganischen Füllstoffs mit der Mischung vor dem Härten.

**11.** Metallbasierte mehrschichtige Leiterplatte umfassend ein Metallsubstrat; eine erste Isolierschicht, die auf dem Metallsubstrat abgeschieden ist und die Harzzusammensetzung gemäß einem der Ansprüche 1 bis 5 enthält; eine Leiterplatte auf der ersten Isolierschicht; eine zweite Isolierschicht, die sich auf der ersten Isolierschicht befindet und die Harzzusammensetzung wie in einem der Ansprüche 1 bis 5 definiert enthält; und eine elektronische Komponente auf der zweiten Isolierschicht, wobei die elektronische Komponente eine hohe Hitzedissipation aufweist.

**12.** Die metallbasierte mehrschichtige Leiterplatte gemäß Anspruch 11, die ferner eine Metallschicht zwischen der ersten Isolierschicht und der zweiten Isolierschicht aufweist.

**13.** Die metallbasierte mehrschichtige Leiterplatte gemäß Anspruch 11 oder 12, worin die zweite Isolierschicht eine Dicke von 50 Mikrometer oder mehr und 200 Mikrometer oder weniger aufweist.

**Revendications**

**1.** Composition de résine comprenant une résine durcissable comprenant :

une résine époxy et un agent durcisseur pour la résine époxy ; et
une charge inorganique chargée dans l'agent durcissable ;
dans laquelle l'agent durcisseur comprend une résine novolaque phénolique, et dans laquelle la charge inorganique comprend une poudre grossière contenant des particules ayant une granulométrie moyenne de 5 à 20 $\mu$m et une poudre fine contenant des particules ayant une granulométrie moyenne de 0,2 à 1,5 $\mu$m ;
dans laquelle au moins la poudre grossière comprend des particules ayant du dioxyde de silicium cristallin.

**2.** Composition de résine selon la revendication 1, dans laquelle la charge inorganique comprend une poudre grossière contenant des particules ayant une granulométrie maximale de 100 $\mu$m ou moins et une granulométrie de 5 à 50 $\mu$m en une quantité de 50 % en volume ou plus, et une poudre fine contenant des particules ayant une granulométrie de 2,0 $\mu$m ou moins en une quantité de 70 % en volume ou plus.

**3.** Composition de résine selon la revendication 1 ou 2, dans laquelle la résine durcissable est présente en une quantité de 25 à 50 % en volume, et dans laquelle la charge inorganique comprend une poudre grossière en une quantité de 34 à 70 % en volume et une poudre fine en une quantité de 3 à 24 % en volume.

**4.** Composition de résine selon l'une quelconque des revendications 1 à 3, dans laquelle chacune de la poudre grossière et de la poudre fine comprend des particules faites en un dioxyde de silicium cristallin.

**5.** Composition de résine selon la revendication 1, dans laquelle la poudre fine comprend des particules faites en un oxyde d'aluminium sphérique.

**6.** Produit en résine durcie comprenant la composition de résine définie dans l'une quelconque des revendications 1 à 5.

**7.** Produit en résine durcie selon la revendication 6, ayant une conductivité thermique de 1,5 à 5,0 W/mK.

**8.** Substrat pour un circuit intégré hybride, comprenant un substrat métallique ; une couche isolante déposée sur le substrat métallique et comprenant la composition de résine définie dans l'une quelconque des revendications 1 à 5 ; et une feuille métallique disposée sur la couche isolante.

9. Substrat pour un circuit intégré hybride selon la revendication 8, dans lequel la feuille métallique est traitée pour former un circuit.

10. Procédé pour préparer la composition de résine définie dans l'une quelconque des revendications 1 à 5, comprenant le mélange d'une résine époxy et d'un agent durcisseur d'une résine novolaque phénolique ; et la combinaison et le mélange d'une charge inorganique avec le mélange avant durcissement.

11. Carte de circuit multicouche à base métallique comprenant un substrat métallique ; une première couche isolante disposée sur le substrat métallique et comprenant la composition de résine définie dans l'une quelconque des revendications 1 à 5 ; une carte de circuit disposée sur la première couche isolante ; une deuxième couche isolante disposée sur la première couche isolante et comprenant la composition de résine définie dans l'une quelconque des revendications 1 à 5 ; et un composant électronique disposé sur la deuxième couche isolante, le composant électronique ayant une dissipation de chaleur élevée.

12. Carte de circuit multicouche à base métallique selon la revendication 11, comprenant en outre une couche métallique disposée entre la première couche isolante et la deuxième couche isolante.

13. Carte de circuit multicouche à base métallique selon la revendication 11 ou 12, dans laquelle la deuxième couche isolante a une épaisseur de 50 $\mu$m ou plus et de 200 $\mu$m ou moins.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2286768 A